# EUROPEAN PATENT APPLICATION

(11) **EP 1 804 512 A2**
(43) Date of publication of application: **04.07.2007**
(21) Application number: 06017762.3
(22) Date of filing: 25.08.2006
(51) Int. Cl.: H04N 7/24

(54) **Digital broadcasting system and method thereof**

(30) Priority: 03.01.2006 KR 20060000562
(71) Applicant: Samsung Electronics Co., Ltd., Yeongtong-gu Suwon-si, Gyeonggi-do (KR)
(72) Inventor: An, Seong-Hyuk, Yeongtong-gu Suwon-si Gyeonggi-do (KR)
(74) Representative: Lang, Johannes

(57) **Abstract**

Disclosed is a digital broadcasting system that includes a broadcasting station for transmitting digital broadcast data through a digital broadcasting network; a server for receiving broadcast information about the digital broadcast data from the broadcasting station, and transmitting the broadcast information through a mobile communication network; and a digital broadcasting receiver for receiving the digital broadcast data and outputting the received digital broadcast data, and receiving and displaying broadcast information which the digital broadcasting receiver requests from the server. Therefore, since broadcast information about digital broadcasts is provided by using the mobile communication network, to which the digital broadcasting receiver of the user is connected at all times, the user can easily check broadcast information even without entering a digital broadcasting mode. Also, the waste of battery power derived from unnecessary access of the digital broadcasting mode is reduced, and the user can view a digital broadcast by accessing the digital broadcasting network as required by the user.

## Description

### BACKGROUND OF THE INVENTION

### 1. Field of the Invention

The present invention relates to digital broadcasting, and more particularly to a digital broadcasting system and a method thereof.

### 2. Description of the Related Art

In general, digital broadcasting refers to broadcasting service for providing users with high image quality, high sound quality, and superior service, replacing conventional analog broadcasting. Digital broadcasting is classified into digital satellite broadcasting and digital terrestrial broadcasting.

Digital satellite broadcasting is intended to provide a mobile service, and enables users to view multi-channel multimedia broadcasts through a portable receiver (e.g. a mobile phone, a personal digital assistant, etc.) or a receiver for a vehicle, whenever and wherever they want.

The digital terrestrial broadcasting, which is based on digital audio broadcasting (DAB), refers to multimedia broadcasting for mobile receivers provided through an unused VHF channel, which compositively transmits television broadcasting, radio broadcasting and data broadcasting by using a multi-channel.

Recently, with the development of digital broadcasting and mobile communication technologies, a digital broadcasting service, which enables the user to view digital broadcasts even while the user is in motion, has drawn increasing attention. Particularly, there is a growing interest in Digital Multimedia Broadcasting (DMB) services using mobile terminals.

When the user of a digital broadcasting receiver wants to see a broadcast program schedule of digital broadcasts or a brief news flash, the user receives corresponding information via an allocated channel after accessing a digital broadcasting network through the digital broadcasting receiver.

However, in this case, since the digital broadcasting receiver has been connected to the digital broadcasting network, the user must pay an additional fee and must operate the digital broadcasting receiver in a digital broadcasting mode while causing unnecessary consumption of battery power.

### SUMMARY OF THE INVENTION

Accordingly, the present invention has been made to solve the above-mentioned problems occurring in the prior art, and an object of the present invention is to provide a digital broadcasting system and method capable of providing broadcast information about digital broadcasts without using a digital broadcasting network.

To accomplish this object, in accordance with one aspect of the present invention, there is provided a digital broadcasting system that includes a broadcasting station for transmitting digital broadcast data through a digital broadcasting network; a server for receiving broadcast information about the digital broadcast data from the broadcasting station, and transmitting the broadcast information through a mobile communication network; and a digital broadcasting receiver for receiving the digital broadcast data and outputting the received digital broadcast data, and receiving and displaying broadcast information that the digital broadcasting receiver requests from the server.

In accordance with another aspect of the present invention, there is provided a digital broadcasting service method in a digital broadcasting system, the method includes requesting broadcast information about digital broadcast data from a digital broadcasting receiver from a server that stores the broadcast information; transmitting the broadcast information from the server to the digital broadcasting receiver via a mobile communication network, in response to the request of the digital broadcasting receiver; and displaying, by the digital broadcasting receiver, the broadcast information received from the server.

### BRIEF DESCRIPTION OF THE DRAWINGS

The above and other objects, features and advantages of the present invention will be more apparent from the following detailed description taken in conjunction with the accompanying drawings, in which:
FIG. 1 is a diagram illustrating the construction of a digital broadcasting system according to the present invention;
FIG. 2 is a block diagram illustrating the construction of a digital broadcasting receiver according to the present invention; and
FIG. 3 is a flowchart illustrating a procedure of providing a digital broadcasting service in the digital broadcasting system according to the present invention.

### DETAILED DESCRIPTION OF THE PREFERRED EMBODIMENT

Hereinafter, preferred embodiments of the present invention will be described with reference to the accompanying drawings. It is to be noted that the same elements are indicated with the same reference numerals throughout the drawings. In the following description of the embodiments of the present invention, a detailed description of known functions and configurations incorporated herein will be omitted when it may obscure the subject matter of the present invention.

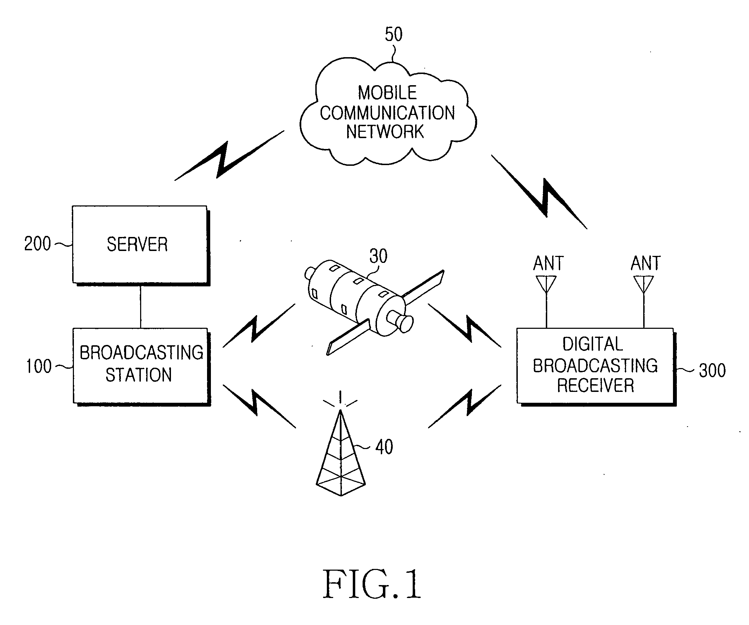

FIG. 1 is a diagram illustrating the construction of a digital broadcasting system according to the present invention.

The digital broadcasting system includes broadcasting stations, illustrated as broadcasting station 100, a server 200, and a digital broadcasting receiver 300. Each broadcasting station 100 converts multimedia data into digital broadcast data, and broadcasts the converted digital broadcast data through a digital broadcasting network. The server 200 provides broadcast information about the digital broadcast data, and the digital broadcasting receiver 300 receives the digital broadcast data and outputs multimedia data obtained from the received digital broadcast data.

According to the present invention, the broadcast information includes a broadcast schedule information about digital broadcast programs, brief news information, and broadcast channel information. The broadcast channel information includes the channel number, program title, a brief description about the program, etc.

The broadcasting station 100 outputs digital broadcast data to the digital broadcasting receiver 300, the server 200 outputs broadcast information about the digital broadcast data. The broadcasting station 100 may include the server 200.

The broadcasting station 100 may output the broadcast information in a predetermined period (e.g. every hour or every day), but it is preferred that the broadcasting station 100 outputs the broadcast information whenever the broadcast information is changed.

When the broadcasting station 100 outputs digital broadcast data to the digital broadcasting receiver 300 through the digital broadcasting network, the digital broadcast data is transmitted through a satellite 30 or a terrestrial repeater 40 to the digital broadcasting receiver 300.

The server 200 receives and stores the broadcast information output from the broadcasting station 100, and transmits the stored broadcast information to the digital broadcasting receiver 300 via a mobile communication network 50 when the broadcast information is requested by the digital broadcasting receiver 300. In this case, it is preferred that the server 200 transmits the broadcast information using a short messaging service (SMS) scheme or an enhanced messaging service (EMS) scheme.

The mobile communication network 50 may be a TDMA (Time Division Multiple Access), CDMA (Code Division Multiple Access), UMTS (Universal Mobile Telecommunications System), or GSM (Global System for Mobile communication) network. The mobile communication network 50 includes a plurality of switching centers (not shown) for establishing communication routes. Herein, each switching center is connected to a plurality of base station controllers (BSCs), each of which is connected to a plurality of base stations (BSs).

Also, each base station is connected to a plurality of mobile stations (MSs) via a terrestrial transmission network, and the base station and the mobile terminals are connected in a TDMA or CDMA scheme so as to transmit packet data (such as an SMS message or EMS message) to each other. In addition, the switching center is connected via a predetermined gateway to a Public Switched Telephone Network (PSTN), an Integrated Services Digital Network (ISDN) or other mobile communication networks, and can be connected to the Internet via an Inter-Workirig Function (IWF) and WAP gateway.

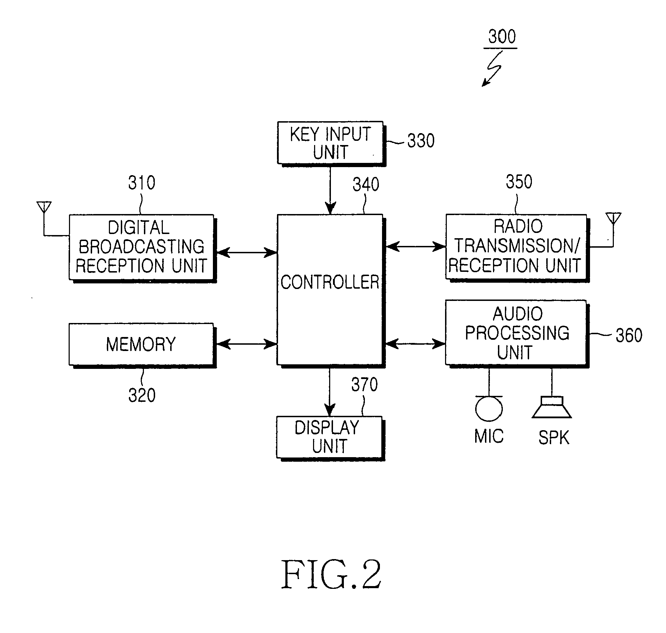

FIG. 2 is a block diagram illustrating the construction of a digital broadcasting receiver according to the present invention.

The digital broadcasting receiver 300 includes a digital broadcasting reception unit 310, a memory 320, a key input unit 330, a controller 340, a radio transmission/reception unit 350, an audio processing unit 360, and a display unit 370.

The digital broadcasting reception unit 310 receives and demodulates a broadcasting frame and outputs the demodulated broadcasting frame to the controller 340, under the control of the controller 340.

The digital broadcasting reception unit 310 may include a demodulator for demodulating the received digital broadcasting frame into a digital data stream.

The memory 320 stores various information required for controlling the operation of the digital broadcasting receiver 300 according to the present invention. Also, the memory 320 stores in advance the address of a server, which has stored broadcast information about digital broadcast data.

The key input unit 330 receives a user's control signal such as key input or voice input, and transmits the received user control signal to the controller 340.

The controller 340 controls the overall operation of the digital broadcasting receiver 300 according to the present invention. Also, the controller 340 decodes the digital broadcasting stream, which has been demodulated and output by the digital broadcasting reception unit 310, and outputs the decoded digital broadcasting stream to the audio processing unit 360 and the display unit 370 via a video signal processor and an audio signal processor.

When broadcast information about digital broadcast data is requested by the user, the controller 340 requests the broadcast information to the server having stored the broadcast information. Herein, the user may request the broadcast information by means of a menu key included in the key input unit 330 or a separate key input. In this case, the controller 340 requests the broadcast information based on the address of the server stored in the memory 320.

When the requested broadcast information is received from the server to by the digital broadcasting receiver 300, the controller 340 displays the received broadcast information through the display unit 370. In this case, the broadcast information received from the server may have the form of a message, for example, may be an SMS message or EMS message. Therefore, the user can check the broadcast information about digital broadcasts through the mobile communication network, without using a digital broadcast channel.

In addition, if the broadcast information received from the server includes broadcast channel information, it is preferred that the controller 340 detects and displays the broadcast channel information through the display unit 370. More pref erably, when the user selects the broadcast channel information, the controller 340 performs a control operation such that the digital broadcasting receiver 300 accesses the broadcast channel and receives a corresponding broadcast. In this case, the broadcast channel information may include the channel number, program title, and a brief description about the program.

The radio transmission/reception unit 350 transmits/receives voice data, text data, image data, and control data under the control of the controller 340. To this end, the radio transmission/reception unit 350 includes an RF transmitter and an RF receiver. The RF transmitter up-converts the frequency of a signal to be transmitted and amplifies the up-converted signal. The RF receiver low-noise amplifies a received signal and down-converts the frequency of the received signal.

The audio processing unit 360 may include a MODEM, which contains a transmitter for encoding and modulating a signal to be transmitted and a receiver for decoding and demodulating the received signal. The audio processing unit 360 modulates an electrical signal input from a microphone MIC to generate voice data, and demodulates encoded voice data input through the radio transmission/reception unit 350 into an electrical signal and outputs the demodulated electrical signal to a speaker SPK. Preferably, the audio processing unit 360 includes a CODEC (Coder/Decoder), which converts a digital audio signal received through the radio transmission/reception unit 350 into an analog audio signal so as to reproduce the analog audio signal, and converts an analog audio signal generated from the microphone into a digital audio signal. The CODEC may include a data CODEC for processing packet data and the like and an audio CODEC for processing an audio signal such as voice, and may be included in the controller 340.

The display unit 370 displays various display data generated in the digital broadcasting receiver 300. Preferably, the display unit 370 utilizes a liquid crystal display (LCD), which can sufficiently support the resolution of digital broadcast data. When the display unit 370 utilizes an LCD of a touch screen scheme, the display unit 370 may serve as an input section.

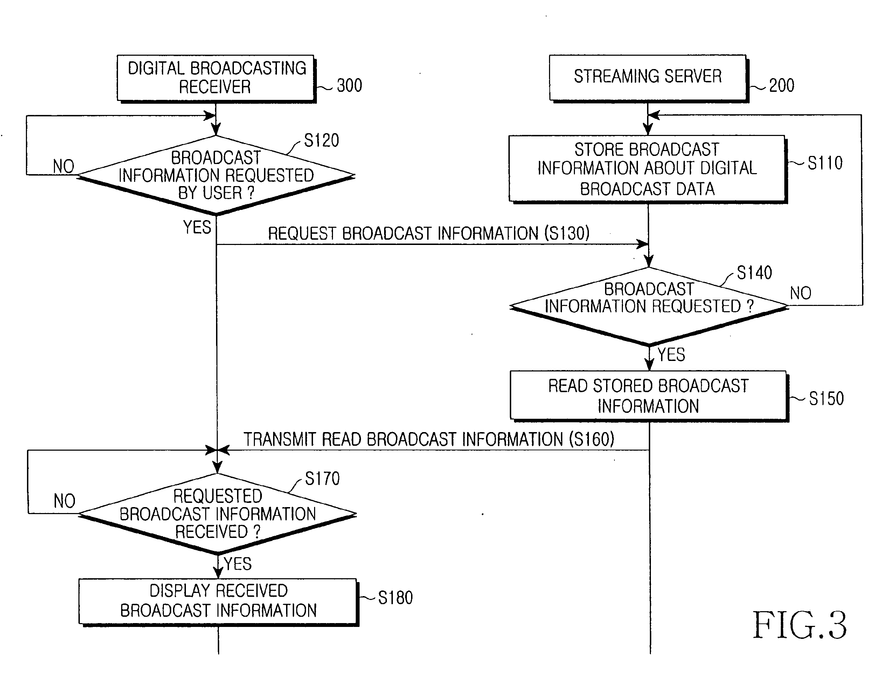

FIG. 3 is a flowchart illustrating a procedure of providing a digital broadcasting service in the digital broadcasting system according to the present invention.

Referring to FIGs. 1 and 3, the server 200 receives broadcast information about digital broadcast data from the broadcasting station 100 and stores the received broadcast information (step 110). The server 200 may be included in the broadcasting station 100. The broadcasting station 100 may output the broadcast information in a predetermined period (e.g. every hour or every day), but it is preferred that the broadcasting station 100 outputs the broadcast information whenever the broadcast information is changed. In this case, it is preferred that the server 200 updates stored broadcast information while deleting the previously-stored broadcast information, whenever the server 200 receives broadcast information.

The digital broadcasting receiver 300 checks whether the user requests broadcast information (step 120). When the user requests broadcast information, the digital broadcasting receiver 300 transmits a broadcast information request message to the digital broadcasting receiver 300 streaming server 200 (step 130). The server 200 checks whether a broadcast information request is received from the digital broadcasting receiver 300 (step 140). When a broadcast information request is received from the digital broadcasting receiver 300, the server 200 reads broadcast information stored therein (step 150). The server 200 transmits the read broadcast information to the digital broadcasting receiver 300 via the mobile communication network 50 (step 160). In this case, it is preferred that the server 200 transmits the read broadcast information using an SMS scheme or EMS scheme. In addition, when the server 200 transmits the broadcast information in a message form, the message may include broadcast channel information about the broadcast information. Then, the digital broadcasting receiver 300 checks whether the digital broadcasting receiver 300 receives the requested broadcast information (step 170). When the digital broadcasting receiver 300 receives the requested broadcast information from the server 200, the digital broadcasting receiver 300 displays the received broadcast information (step 180).

Accordingly, the user can check information about digital broadcasts through the displayed broadcast information, and the user can view a digital broadcast received to by the digital broadcasting receiver 300 via the digital broadcasting network when wanting to view the digital broadcast. In addition, when a message (i.e. a message including broadcast information) received from the server 200 to by the digital broadcasting receiver 300 includes broadcast channel information, the digital broadcasting receiver 300 may detect and display the broadcast channel information through the display unit 370. In this case, when the user selects the displayed broadcast channel information, the digital broadcasting receiver 300 may directly access the broadcast channel so as to receive the corresponding broadcast.

As described above, according to the digital broadcasting system and method of the present invention, since broadcast information about digital broadcasts is provided by using the mobile communication network, to which the digital broadcasting receiver of the user is connected at all times, the user can easily check broadcast information even without entering a digital broadcasting mode.

In addition, the waste of battery power derived from unnecessary use of the digital broadcasting mode is reduced, and the user can view a digital broadcast by accessing the digital broadcasting network as required by the user.

While the present invention has been shown and described with reference to certain preferred embodiments thereof, it will be understood by those skilled in the art that various changes in form and details may be made therein without departing from the spirit and scope of the invention as defined by the appended claims. Accordingly, the scope of the invention is not to be limited by the above embodiments but by the claims and the equivalents thereof.

## Claims

1. A digital broadcasting system, comprising:
a broadcasting station for transmitting digital broadcast data through a digital broadcasting network;
a server for receiving broadcast information about the digital broadcast data from the broadcasting station, and transmitting the broadcast information through a mobile communication network; and
a digital broadcasting receiver for receiving the digital broadcast data and outputting the received digital broadcast data, and receiving and displaying broadcast information that the digital broadcasting receiver requests from the server.

2. The digital broadcasting system as claimed in claim 1, wherein the broadcast information includes broadcast schedule information at least one of about a digital broadcast program, brief news information, and broadcast channel information.

3. The digital broadcasting system as claimed in claim 1, wherein, whenever the broadcast information is changed, the broadcasting station transmits the changed broadcast information to the server.

4. The digital broadcasting system as claimed in claim 1, wherein the broadcasting station includes the server.

5. The digital broadcasting system as claimed in claim 1, wherein the server transmits the broadcast information using one of a short messaging service (SMS) and enhanced messaging service (EMS) scheme.

6. The digital broadcasting system as claimed in claim 1, wherein the digital broadcasting receiver detects and displays broadcast channel information when the broadcast information includes the broadcast channel information.

7. The digital broadcasting system as claimed in claim 6, wherein the digital broadcasting receiver accesses a broadcast channel of the displayed broadcast channel information so as to receive digital broadcast data, when the displayed broadcast channel information is selected by a user.

8. A digital broadcasting service method in a digital broadcasting system, the method comprising the steps of:
requesting broadcast information about digital broadcast data from by a digital broadcasting receiver from a server which stores the broadcast information therein;
transmitting the broadcast information from the server to the digital broadcasting receiver via a mobile communication network, in response to the request of the digital broadcasting receiver; and
displaying, by the digital broadcasting receiver, the broadcast information received from the server.

9. The method as claimed in claim 8, wherein the broadcast information includes at least one of broadcast schedule information about a digital broadcast program, brief news information, and broadcast channel information.

10. The method as claimed in claim 8, further comprising receiving at the server the broadcast information from a broadcasting station, which transmits digital broadcast data, and storing in the server the broadcast information.

11. The method as claimed in claim 10, wherein the server stores the broadcast information therein by periodically receiving the broadcast information.

12. The method as claimed in claim 10, wherein the server receives and stores the broadcast information therein whenever the broadcast information is changed.

13. The method as claimed in claim 8, wherein the server transmits the broadcast information by using one of a short messaging service (SMS) and enhanced messaging service (EMS) scheme.

14. The method as claimed in claim 8, wherein the displaying step further comprises accessing a broadcast channel of broadcasting channel information so as to receive digital broadcast data when the broadcast channel information is selected by a user, in a case in which the displayed broadcast information includes the broadcast channel information.
